# EUROPÄISCHE PATENTSCHRIFT

(11) **EP 0 525 279 B1**
(45) Veröffentlichungstag und Bekanntmachung des Hinweises auf die Patenterteilung: **21.09.1994**
(21) Anmeldenummer: 92102290.1
(22) Anmeldetag: 12.02.1992
(51) Int. Cl.: C23C 14/50, C23C 14/54, C23C 14/56, H01L 21/00, C23C 16/46

(54) **Vorrichtung für den Transport von Substraten**
Apparatus for transporting substrates
Dispositif pour le transport des substrats

(30) Priorität: 31.07.1991 DE 4125334
(43) Veröffentlichungstag der Anmeldung: 03.02.1993
(73) Patentinhaber: LEYBOLD AKTIENGESELLSCHAFT, D-63450 Hanau (DE)
(72) Erfinder: Latz, Rudolf, Dr., W-6074 Rodgau 2 (DE)

(56) Entgegenhaltungen:
- EP-A- 0 346 815
- DE-A- 3 830 963
- DE-A- 3 941 502
- PATENT ABSTRACTS OF JAPAN vol. 9, no. 19 (E-292)(1742) 25. Januar 1985; & JP-A-59 167 013
- PATENT ABSTRACTS OF JAPAN vol. 12, no. 82 (C-481)(2929) 15. März 1988; & JP-A-62 218 568

## Beschreibung

Die Erfindung betrifft eine Vorrichtung für die Wärmebehandlung und den Transport von Substraten bei Vakuumbeschichtungsanlagen mit mehreren Stationen, mit Substrathaltern mit etwa plattenförmiger, flacher, parallelepipeder Konfiguration, die in lotrechter Stellung - entlang eines vorgegebenen Transportweges - durch die Stationen bewegbar sind, und mit Paaren von Wälzkörpern, Gleitsteinen oder Rollen, die im Zusammenwirken mit Schienen die Substrathalter halten und führen und die jeweils im Bereich ihres Fußteils unterhalb der an den Substrathaltern befestigbaren Substraten vorgesehen sind, wobei der Substrathalter eine sich von oben her bis in den Bereich seines Fußteils erstreckende, parallel zu den Schienen verlaufende, schachtförmige Aussparung aufweist, in die beim Durchlauf durch die Station ein oberhalb des Substrathalters am oberen Wandteil angeordneter, flacher, sich lotrecht nach unten zu erstreckender Heizkörper hineinragt.

Die zum Einsatz kommenden Substrathalter sind entweder Platten mit entsprechend den Substraten geformten Ausschnitten oder Rahmen mit Streben, an denen die Substrate befestigt werden. Im allgemeinen dient ein Substrathalter zur Aufnahme einer Vielzahl von Substraten.

Durch die US-PS 4,042,128 ist eine Transporteinrichtung der eingangs beschriebenen Gattung bekannt, bei der plattenförmige Substrathalter bei vertikaler Lage ihrer Hauptebene an ihren oberen und unteren Längskanten zwischen Rollen geführt werden, die um senkrechte Achsen drehbar sind. An ihren Unterkanten liegen die Substrathalter zusätzlich auf Stützrollen mit horizontaler Drehachse auf. Die unteren Führungsrollen sind jedoch nicht im Stande, die Substrathalter allein in genau vertikaler Stellung zu halten und zu transportieren, so daß eine stabile Positionierung nur unter Zuhilfenahme der oberen Führungsrollen möglich ist.

Bekannt ist auch eine Transporteinrichtung für Vakuumbeschichtungsanlagen (EP 0 254 145 B1) mit mehreren Stationen und mit Rollensystemen für die Führung und den Vorschub von im wesentlichen zweidimensionalen Substrathaltern in senkrechter Stellung, entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achsen drehbar sind, wobei die Substrathalter ausschließlich im Bereich ihrer Unterkante durch die Rollensysteme geführt sind und die Führungsrollen mit Laufflächen versehen sind, die auf mindestens einer Führungsrolle eines Rollenpaares jeweils am unteren und am oberen Ende angeordnet sind, wobei die jeweils andere Führungsrolle des gleichen Rollenpaares mindestens eine Lauffläche aufweist und wobei die mindestens drei Laufflächen eines Rollenpaares in bezug auf den Substrathalter eine kippsichere Einspannung bilden.

Weiterhin ist es bekannt (DE 31 07 914), die zu beschichtenden Substrate in einer besonderen Schleusenkammer mit einer Heizeinrichtung thermisch vorzubehandeln. Bekannt ist es auch, den Substrathalter bei einer Transporteinrichtung für eine Vakuumbeschichtungsanlage mit einem Fußteil auszustatten, das auf ortsfesten Schienen gleitet (EP 0 346 815).

Schließlich wurde bereits eine Vorrichtung vorgeschlagen (EP-A-0.476.219) mit mehreren Stationen, mit Substrathaltern mit etwa plattenförmiger Konfiguration, die in lotrechter Stellung entlang eines vorgegebenen Transportweges bewegbar sind und die mit Schienen zusammenwirken, die jeweils im Bereich ihres Fußteils unterhalb der an den Substrathaltern befestigbaren Substraten vorgesehen sind, wobei das Fußteil des Substrathalters mit einem Paar paralleler Schienen versehen ist, deren Längsnuten mit Rollen korrespondieren, die ortsfest am Bodenteil der Vorrichtung gelagert sind und die jeweils in Reihen entsprechend dem Verlauf der Nuten in übereinander liegenden, vertikalen Ebenen im Abstand zueinander vorgesehen sind, wobei der Substrathalter eine sich von oben her erstreckende, parallel zu den Schienen verlaufende, schachtförmige Aussparung aufweist, in die beim Durchlauf durch die Station ein oberhalb des Substrathalters am oberen Wandteil angeordneter, flacher, sich lotrecht nach unten zu erstreckender Heizkörper hineinragt.

Dieser älteren Transporteinrichtung lag die Aufgabe zugrunde, eine Substrathalterung für mehrere Substrate zu schaffen und diese so auszubilden, daß die Substrate gemeinsam von einer einzigen Heizquelle gleichzeitig und mit gleicher Intensität temperierbar sind.

Der vorliegenden Erfindung liegt insbesondere die Aufgabe zugrunde, eine Vorrichtung der in Frage stehenden Art zu schaffen, die geeignet ist, die elektrischen und die optischen Schichteigenschaften auf nichthitzebeständigen Substraten durch Temperieren zu verbessern und insbesondere die Vorrichtung so zu gestalten, daß die Temperatur in der Umgebung der Substrate vergleichsweise gering gehalten wird.

Diese Aufgabe wird erfindungsgemäß dadurch gelöst, daß der aus einem magnetischen Werkstoff gebildete, finger- oder plattenförmige Heizkörper zumindest eine vom elektrischen Strom durchflossene Leiterschleife aufweist, die mit zweckmäßigerweise an den dem Heizkörper abgewandten Seitenflächen der Substrate angeordneten Platten aus elektrisch leitfähige Werkstoff zusammenwirkt und mit dieser ein Induktionsheizelement bildet.

Vorzugsweise weist der Substrathalter zwei rahmenförmig ausgebildete, in parallelen Ebenen angeordnete Seitenteile auf, die zwischen sich die schachtförmige Aussparung bilden, in deren fensterartige Öffnungen die Substrate einlegbar sind, wobei die Seitenteile einstückig ausgebildet sind oder mit dem Fußteil vernietet, verschraubt oder über Gelenke verbunden sind und wobei die Platten aus elektrisch leitfähigem Werkstoff in ihren äußeren Abmessungen so dimensioniert sind, daß sie in die fensterförmigen Ausnehmungen einsetzbar und dort arretierbar sind.

Weitere bevorzugte Ausführungsformen sind in den abhängigen Ansprüchen 2 und 3 offenbart.

Die Erfindung läßt die verschiedensten Ausführungsmöglichkeiten zu; eine davon ist in der anhängenden Zeichnung schematisch näher dargestellt, die den Schnitt quer durch eine Vorrichtung zeigt.

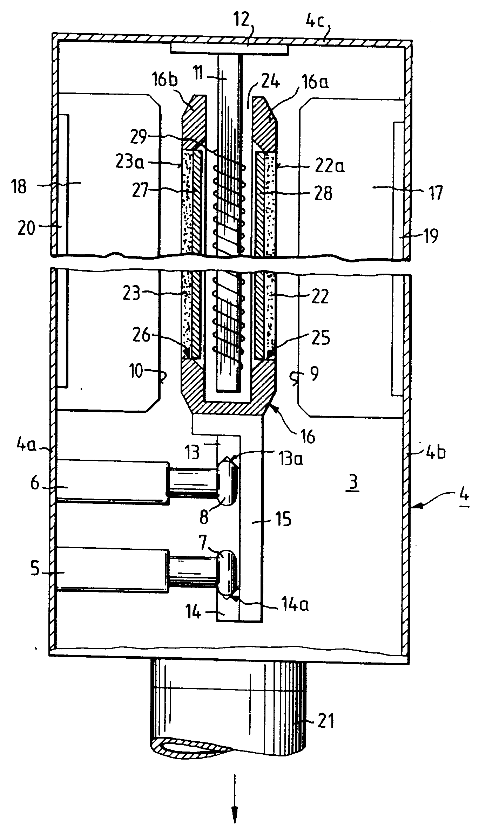

Wie die Zeichnung zeigt, besteht die Vorrichtung aus den in der Beschichtungskammer 3 an der einen Seitenwand 4a des Gehäuses 4 an sich horizontal erstreckenden Armen 5, 6 drehbar gelagerten Rollen 7, 8, den beiden an den Seitenwänden 4a, 4b fest angeordneten Kathoden 9, 10, dem am oberen Wandteil 4c bzw. am Isolator 12 gehaltenen plattenförmigen, von einer Leiterschleife 29 umschlossenen Element 11, dem mit Schienen 13, 14 versehene Fußteil 15 des im Querschnitt U-förmig ausgeformten Substrathalters 16, den beiden rahmenförmigen, die Substrate 22, 23 und die Platten 27, 28 haltenden Seitenteilen 16a, 16b des Substrathalters 16 und den beiden an den Seitenwänden 4a, 4b fest angeordneten Kathoden 19, 20 mit ihren Kathodenblenden 17, 18 und schließlich dem Absaugstutzen 21 einer nicht näher dargestellten Turbomolekularpumpe.

Während des Betriebs der in der Zeichnung schematisch dargestellten Beschichtungsstation werden die Substrate 22, 23 in einer Richtung lotrecht zur Schnittebene bewegt, bis sie den Kathoden 19, 20 gegenüberstehen, wie dies aus der Zeichnung ersichtlich ist.

Nach der Beschichtung der Außenflächen 22a, 23a der Substrate 22, 23 werden diese in der gleichen Richtung (lotrecht zur Zeichenebene) bis zur nächsten Bearbeitungsstation weiterbewegt. Die scheibenförmigen Substrate 22, 23 und auch die Platten aus elektrisch leitendem Werkstoff 27, 28 werden von den sie rahmenförmig umschließenden Seitenteilen 16a, 16b des Substrathalters 16 gehalten, der seinerseits fest mit dem Fußteil 15 verbunden oder einstückig mit diesem ausgebildet ist. Das Fußteil 15 ist mit einem Paar von Schienen 13, 14 verschraubt oder verschweißt, die ihrerseits Längsnuten 13a, 14a aufweisen, in denen Rollen 7 bzw. 8 laufen, die in zwei Reihen in Abständen hintereinanderliegend drehbar auf Armen 5 bzw. 6 gelagert sind. Der Abstand, den die Reihen von Rollen 5 bzw. 6 zueinander aufweisen, ist so gewählt, daß das Fußteil 15 auf diesen kippsicher gehalten und geführt ist.

Um sicherzustellen, daß die Substrate 22, 23 die für den Beschichtungsprozeß erforderliche Temperatur aufweisen, ist am oberen Wandteil 4c des Gehäuses 4 an einem Isolator 12 ein plattenförmiges Element 11, das von einer stromdurchflossenen Leiterschleife oder einer Drahtspule 29 umschlossen ist, befestigt, das in die schachtförmige Nut 24 hineinragt und das so bemessen ist, daß die Substrate 22, 23 von ihrer einen Seitenfläche her infolge Induktion gleichmäßig aufgeheizt werden. Um Strahlungsverluste möglichst gering und die Temperierung beider Substrate 22, 23 auf gleichem Niveau zu halten, sind die jeweils zwischen dem Heizelement 11 und den Substraten 22, 23 verbleibenden Abstände gleich und möglichst gering bemessen.

Es ist klar, daß die Leiterschleife 29 nicht nur in Verbindung mit auf der Rückseite der Substrate 22, 23 angeordneten Metallplatten 27, 28 im Sinne eines Induktions-Heizkörpers zusammenwirkt, sondern auch mit auf der Vorder- oder Rückseite der Substrate aufgebrachten Schichten aus elektrisch leitendem Werkstoff. Ebenso können Metallfolien auf die Substrate aufgeklebt sein, die zusammen mit der Leiterschleife 29 einen Induktionsheizer bilden.

Ein wesentlicher Vorteil besteht insbesondere darin, daß die einzusetzende Wärme nur in dem Augeblick erzeugt wird, wenn sich das Substrat unmittelbar vor dem Heizer 11, 29 befindet, so daß die Anlage selbst sich nicht weiter aufheizt und die Wärme - örtlich begrenzt - besonders gut kontrolliert werden kann.

### Bezugszeichenliste

- 3: Beschichtungskammer
- 4: Gehäuse
- 4a: Seitenwand des Gehäuses
- 4b: Seitenwand des Gehäuses
- 4c: oberes Wandteil des Gehäuses
- 5: Arm
- 6: Arm
- 7: Rolle
- 8: Rolle
- 9: Kathode
- 10: Kathode
- 11: plattenförmiges Element, Wickelkörper
- 12: Isolator
- 13: Schiene
- 13a: Längsnut
- 14: Schiene
- 14a: Längsnut
- 15: Fußteil
- 16: Substrathalter
- 16a: Seitenteil des Substrathalters
- 16b: Seitenteil des Substrathalters
- 17: Kathodenblende
- 18: Kathodenblende
- 19: Kathode
- 20: Kathode
- 21: Absaugstutzen
- 22: Substrat
- 22a: Außenfläche des Substrats
- 23: Substrat
- 23a: Außenfläche des Substrats
- 24: schachtförmige Nut
- 25: fensterförmige Ausnehmung
- 26: fensterförmige Ausnehmung
- 27: Metallplatte
- 28: Metallplatte
- 29: Leiterschleife

## Patentansprüche

1. Vorrichtung für den Transport von Substraten bei Vakuumbeschichtungsanlagen mit mehreren Stationen, mit Substrathaltern (16) mit etwa plattenförmiger, flacher, parallelepipeder Konfiguration, die in lotrechter Stellung entlang eines vorgegebenen Transportweges durch die Stationen bewegbar sind und die mit Schienen (13, 14) zusammenwirken, die jeweils im Bereich ihres Fußteils (15) unterhalb der an den Substrathaltern (16) befestigbaren Substraten (22, 23) vorgesehen sind, wobei der Substrathalter (16) eine sich von oben her bis in den Bereich seines Fußteils (15) erstreckende, parallel zu den Schienen (13, 14) verlaufende, schachtförmige Aussparung (24) aufweist, in die beim Durchlauf durch die Station ein oberhalb des Substrathalters (16) am oberen Wandteil (4c) angeordneter, flacher, sich lotrecht nach unten zu erstreckendes Element (11) hineinragt, **dadurch gekennzeichnet**, daß das aus einem magnetischen Werkstoff gebildete, finger- oder plattenförmige Element (11) zumindest eine vom elektrischen Strom durchflossene Leiterschleife (29) aufweist, die mit an den dem Element (11) abgewandten Seitenflächen der Substrate (22, 23) angeordneten oder mit den Substraten fest verbundenen Platten, Folien oder Schichten aus elektrisch leitfähigem Werkstoff (27, 28) zusammenwirkt und mit diesem ein Induktions-Heizelement bildet.

2. Vorrichtung nach Anspruch 1, **dadurch gekennzeichnet**, daß der Substrathalter (16) zwei rahmenförmig ausgebildete, in parallelen Ebenen angeordnete Seitenteile (16a, 16b) aufweist, die zwischen sich die schachtförmige Aussparung (24) bilden und in deren fensterartige Öffnungen (25, 26) die Substrate (22, 23) einlegbar sind, wobei die Seitenteile (16a, 16b) einstückig ausgebildet sind oder mit dem Fußteil (15) vernietet, verschraubt oder über Gelenke verbunden sind und wobei die Platten oder Folien (27, 28) aus elektrisch leitfähigem Werkstoff in ihren äußeren Abmessungen so dimensioniert sind, daß sie in die fensterförmigen Ausnehmungen (25, 26) einsetzbar und dort arretierbar sind.

3. Vorrichtung nach Anspruch 1, **dadurch gekennzeichnet**, daß die Platten (27, 28) aus elektrisch leitfähigem Werkstoff einstückig mit den Substraten (22, 23) ausgebildet sind, als Schicht auf der Rückseite oder der den Kathoden (19, 20) zugewandten Seitenfläche der Substrate (22, 23) angeordnet sind.

## Claims

1. Device for the transport of substrates in vacuum-coating plants having several stations, with substrate holders (16) of roughly plate-shaped, flat, parallelepipedic configuration which in vertical position are capable of being moved through the stations along a predetermined transport path and which interact with rails (13, 14) which are each provided in the region of their base part (15) below the substrates (22, 23) that are capable of being attached to the substrate holders (16), whereby the substrate holder (16) exhibits a shaft-like recess (24) which extends from above into the region of its base part (15) and which runs parallel to the rails (13, 14) and into which there projects, when passing through the station, a flat element (11) extending vertically downwards and arranged above the substrate holder (16) on the upper part (4c) of the wall, characterised in that the finger-shaped or plate-shaped element (11) formed from a magnetic material exhibits at least one conductor loop (29) through which electric current passes, whereby said conductor loop interacts with plates, foils or layers consisting of electrically conductive material (27, 28) which are arranged on the lateral faces of the substrates (22, 23) facing away from the element (11) or which are rigidly connected to the substrates and said conductor loop together with said conductive material constitutes an induction heating element.

2. Device according to Claim 1, characterised in that the substrate holder (16) exhibits two frame-shaped side parts (16a, 16b) arranged in parallel planes, whereby said side parts form between themselves the shaft-like recess (24) and the substrates (22, 23) are capable of being placed into the window-type openings (25, 26) of said side parts, whereby the side parts (16a, 16b) are formed in one piece or are riveted or screwed together or connected via joints to the base part (15) and whereby the plates or foils (27, 28) consisting of electrically conductive material have external dimensions such that they are capable of being inserted into the window-type openings (25, 26) and secured in position therein.

3. Device according to Claim 1, characterised in that the plates (27, 28) are formed in one piece with the substrates (22, 23) from electrically conductive material and are arranged as a layer on the back of the substrates (22, 23) or on the lateral face thereof facing the cathodes (19, 20).

## Revendications

1. Dispositif pour le transport de substrats dans des installations de revêtement sous vide comprenant plusieurs stations munies de porte-substrats (16) d'une configuration à peu près en forme de plaque, plate, parallèlépipédique, qui peuvent circuler en position verticale à travers les stations, le long d'un trajet de transport prédétermine, qui coopèrent avec des rails (13, 14) qui sont prévus chacun dans la région de leur partie de pied (15) au-dessous des substrats (22, 23) qui peuvent être fixés aux porte-substrats (16), le porte-substrat (16) présentant un évidement (24) en forme de puits, qui se prolonge du haut jusque dans la région de sa partie de pied (15), et s'étend parallèlement aux rails (13, 14), évidement dans lequel un élément (11) fixé à la partie de paroi supérieure (4c) au-dessus du porte-substrat (16), et qui s'étend verticalement vers le bas, plonge lors du passage à travers la station, caractérisé en ce que l'élément (11) en forme de doigt ou de plaque, fait d'une matière magnétique, présente au moins une boucle conductrice (29) parcourue par le courant électrique, qui coopère avec des plaques, feuilles ou couches faites d'une matière conductrice de l'électricité (27, 28) disposées sur les surfaces latérales des substrats (22, 23) qui sont éloignées de l'élément (11), ou qui sont fixées rigidement aux substrats, et forme un élément chauffant à induction avec ces plaques, feuilles ou couches.

2. Dispositif selon la revendication 1, caractérisé en ce que le porte-substrat (16) présente deux parties latérales (16a, 16b) en forme de cadre, disposées dans des plans parallèles, qui forment entre elles l'évidement (24) en forme de puits, et dans les ouvertures (25, 26) en forme de fenêtres desquelles les substrats (22, 23) peuvent être placés, les parties latérales (16a, 16b) étant réalisées en une seule pièce, ou fixées à la partie de pied (15) par des rivets, des vis, ou à l'aide d'articulations, les plaques ou feuilles (27, 28) en matière conductrice de l'électricité ayant des dimensions extérieures telles qu'elles puissent être encastrées dans les évidements (25, 26) en forme de fenêtres et y être immobilisées.

3. Dispositif selon la revendication 1, caractérisé en ce que les plaques (27, 28) en matière conductrice de l'électricité sont en une seule pièce avec les substrats (22, 23), en constituant une couche sur la face arrière des substrats ou sur les surfaces latérales des substrats (22, 23) qui sont dirigées vers les cathodes (19, 20).
